# EUROPÄISCHE PATENTSCHRIFT

(11) **EP 0 597 200 B1**
(45) Veröffentlichungstag und Bekanntmachung des Hinweises auf die Patenterteilung: **25.09.1996**
(21) Anmeldenummer: 93113518.0
(22) Anmeldetag: 24.08.1993
(51) Int. Cl.: H03K 17/16, G11C 27/02

(54) **GaAs-FET-Analogschalter**
GaAs-FET analog switch
Commutateur analogique avec FET-AsGa

(30) Priorität: 10.11.1992 DE 4237925
(43) Veröffentlichungstag der Anmeldung: 18.05.1994
(73) Patentinhaber: FRAUNHOFER-GESELLSCHAFT ZUR FÖRDERUNG DER ANGEWANDTEN FORSCHUNG E.V., 80636 München (DE)
(72) Erfinder: Feng, Shen, D-91054 Erlangen (DE); Sauerer, Josef, D-91074 Herzogenaurach (DE); Seitzer, Dieter, D-91054 Erlangen (DE)
(74) Vertreter: Schoppe, Fritz, Dipl.-Ing.

(56) Entgegenhaltungen:
- EP-A- 0 020 160
- ELEKTRONIK , Bd. 39, Nr. 5 , 2. März 1990 , MUNCHEN,DE Seiten 100 - 110 J. WALTER ET. AL. 'Integrierbare Funktionblocke und Systeme'
- ELECTRONICS LETTERS Bd. 24, Nr. 15 , 21. Juli 1988 , STEVENAGE, GB Seiten 982 - 984 S. HARROLD 'SWITCH-DRIVER CIRCUIT SUITABLE FOR HIGH-ORDER SWITCHED-CAPACITOR FILTERS IMPLEMENTED IN GaAs'

## Beschreibung

Die vorliegende Erfindung betrifft einen FET-Analogschalter mit einem Eingangsknoten, an den ein abzutastendes Analogsignal anlegbar ist, einem Ausgangsknoten, an den ein Abschlußelement anschließbar ist, einem Schalttransistor, der zwischen dem Eingangsknoten und dem Ausgangsknoten angeordnet ist und mit einer Treiberschaltung für die Ansteuerung des Gates des Schalttransistors in Abhängigkeit von einem Abtaststeuersignal.

Analogschalter sind Schlüsselkomponenten bei der Entwicklung analoger Abtastschaltungen. Die Anwendungsgebiete sind Abtasthalteglieder, Schalter-Kondensatorfilter (SC-Filter), Schalter-Stromfilter (SI-Filter), selbsteichende Strukturen für Operationsverstärker und Komperatoren und entsprechende Digital/Analog- und Analog/Digital-Umsetzer (DAU und ADU). In Abtasthaltegliedern, die eine wesentliche Bedeutung bei ADU und DAU haben, wird der Analogschalter mit einer Kapazität am Ausgang abgeschlossen, wodurch im ausgeschalteten Zustand die Spannung im Abschaltaugenblick gespeichert wird. Bei SC-Filtern wird mit den Schaltern und einem Kondensator ein äquivalenter Widerstand gebildet. Bei hochgenauen Operationsverstärkern und Komparatoren kann durch eine Schalter-Kondensatorkombination ein Selbstabgleich erreicht werden. Ein jüngstes Anwendungsbeispiel ist bei Schalter-Stromfiltern, wobei durch den Einsatz des Analogschalters zusammen mit anderen Transistoren ein dynamischer Stromspiegel als wesentliche Struktur verwendet wird.

Analogschalter müssen hinsichtlich der Geschwindigkeit und Genauigkeit hohe Anforderungen erfüllen. Es hat sich erwiesen, daß aus GaAs-Feldeffekttransistoren aufgebaute Analogschalter für höhere er Arbeitsfrequenzen und Arbeitsgeschwindigkeiten geeigneter sind als solche Analogschalter, die in Si-MOS-Technologie realisiert sind, da die Elektronenbeweglichkeit in GaAs wesentlich höher ist als diejenige in Si.

GaAs-FET-Analogschalter als Bestandteile von Abtastschaltungen, die Schaltfrequenzen von 100 MHz bis einige GHz erreichen, sind aus folgenden Literaturstellen bekannt:

Haigh, D.G., Toumazou, C., Harrold, S.J., Steptoe, K., Sewell, J.I., Bayruns, R.: Design Optimization and Testing of a GaAs Switched-Capacitor Filter. IEEE Trans.on CAS, Vol. 38, Nr.8, Aug. 1991, S.825-837.

Fawcett, K., Hafizi, M., Lin, S., Myers, D., Esfandiari, R., Kim, M., Williams, T., Englekirk, M.: High-Speed, High-Accuracy, Self-Calibrating GaAs MESFET Voltage Comparator for A/D Converter, IEEE GaAs IC Symp., Okt. 1986, S.213-216.

Naber, J.F., Singh, H.P., Sadler, R.A.: A Fast-Settling GaAs Enhanced Frequency Synthesizer. IEEE GaAs IC Symp., Okt. 1991, S. 353-356.

Toumazou, C.; Battersby, N.C.: High Speed GaAs Switched Current Techniques for Analogue Sampled-Data Signal Processing. Electronics Letters, Vol.28, Nr.7, März 1992, S. 689-690.

Gleichfalls ist es bekannt, daß diese hohen Geschwindigkeiten von GaAs-FET-Analogschaltern die Anwendung von SC-Filtern zur Realisierung überabtastender A/D-Umsetzer in GaAs-Technologie ermöglichen. Diesbezüglich wird verwiesen auf:

Asibal, R.L., Allen, P.E.: Design Issues in GaAs Oversampled A/D Converters. IEEE ISCAS '91, Mai 1991, S. 1841-1844.

Bisher wurde bei dem Entwurf von GaAS-FET-Analogschaltern versucht, einen großen Eingangsspannungsbereich unter Berücksichtigung des Frequenzganges und des Transientenverhaltens zu erzielen. Diesbezüglich wird auf folgende Literaturstellen verwiesen:

Haigh, D.G., Toumazou, C., Harrold, S.J., Steptoe, K., Sewell, J.I., Bayruns, R.: Design Optimization and Testing of a GaAs Switched-Capacitor Filter. IEEE Trans.on CAS, Vol. 38, Nr.8, Aug. 1991, S.825-837.

Larson, L.E., Martin, K.W., Temes, G.C.: GaAs Switched Capacitor Circuits for High Speed Signal Processing. IEEE J. of SSC, Vol.22, Nr. 6, Dezember 1987, S. 971-981.

Harrold, S.J.: Switch Driver Circuit Suitable for High Order Switched Capacitor Filters Implemented in GaAs. Electronics Letters, Vol.24, Juli 1988, S.982-984.

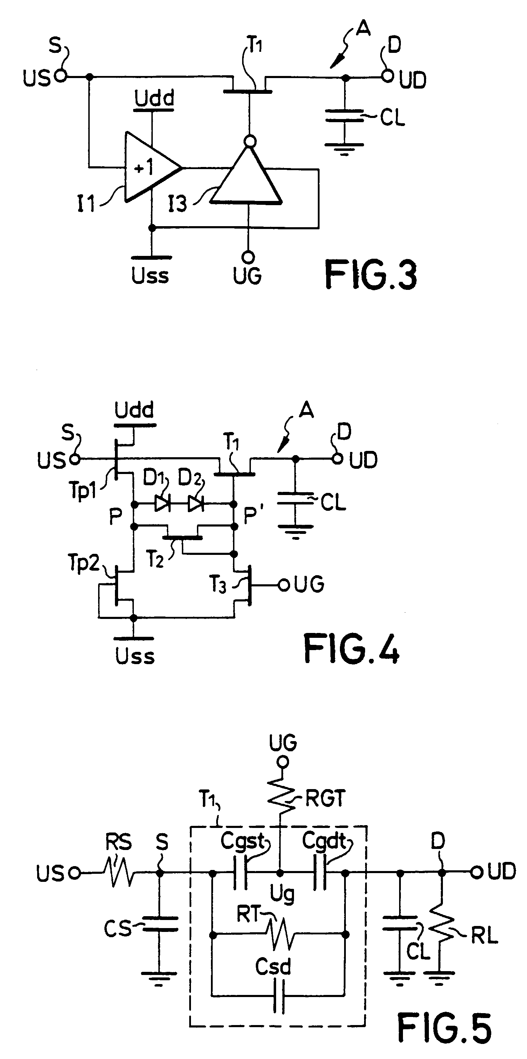

Die bekannten FET-Analogschalter mit einem großen Eingangsspannungsbereich haben ein Ersatzschaltbild, das in Fig. 3 wiedergegeben ist, wobei die Detailschaltung in Fig. 4 gezeigt ist.

Bei dem in Fig. 3 gezeigten Ersatzschaltbild eines solchen bekannten GaAs-FET-Analogschalters, der in seiner Gesamtheit mit dem Bezugszeichen A bezeichnet ist, ist der Eingangsknoten S des Analogschalters A direkt mit der Source-Elektrode eines Schalttransistors T1 Verbunden, dessen Drain-Elektrode den Ausgangsknoten D der Schaltung bildet, an welchen ein Abschlußelement in Form eines Haltekondensators CL angeschlossen ist, der gegen ein Bezugspotential geschaltet ist.

Das Gate des Schalttransistors wird durch eine Treiberschaltung in Abhängigkeit von einem Abtaststeuersignal UG angesteuert. Die Treiberschaltung umfaßt eine Impedanzwandlerschaltung I1, die mit den beiden Versorgungspotentialen Udd und Uss versorgt wird und deren Eingang mit dem Eingangsknoten S der Schaltung verbunden ist. Ferner ist eine Inverterschaltung I3 vorgesehen, der eingangsseitig das Abtaststeuersignal UG zugeführt wird, und die ausgangsseitig mit dem Gate des Schalttransistors T1 verbunden ist, wobei diese Inverterschaltung I3 von dem Ausgang des Impedanzwandlers I1 einerseits und von einer Referenzspannung Uss andererseits versorgt wird.

Bei der Detailschaltung gemäß Fig. 4 wird die soeben beschriebene Treiberschaltung durch zwei Puffertransistoren Tp1, Tp2 gebildet, die mit ihren Drain-Source-Strecken in Reihe miteinander zwischen den beiden Versorgungspotentialen liegen, wobei das Gate des einen Puffertransistors Tp1 mit dem Eingangsknoten S und dasjenige des zweiten Puffertransistors Tp2 mit dem zweiten Versorgungspotential Uss verbunden ist. Der Inverter wird durch einen Invertertransistor T3 gebildet. Zwischen dem gemeinsamen Knoten der beiden Puffertransistoren Tp1, Tp2 welcher der Source-Elektrode des ersten Puffertransistors Tp1 entspricht, und der Gate-Elektrode des Schalttransistors T1 liegt die Drain-Source-Strecke eines zweiten Transistors T2, dessen Gate gleichfalls mit dem Gate des Schalttransistors T1 verbunden ist. Die beiden Puffertransistoren Tp1, Tp2 und der zweite Transistor T2 bilden zusammen den Inverter I1.

Aus den nachfolgend erläuterten Gründen liegt zwischen der Source-Elektrode des ersten Puffertransistors Tp1 und der Gate-Elektrode des Schalttransistors T1 die Reihenschaltung zweier Dioden D1, D2.

Allgemein sind die Parameter, die die Genauigkeit der Abtastschaltung gemäß Fig. 3 begrenzen, deren Durchlaßdämpfung, Sperrdämpfung, der Taktdurchgriff sowie die Ladungsverschiebung bei dem Schaltvorgang.

In Si-MOS-Technologie sind die Gates der Transistoren durch eine Oxidschicht vom Kanal isoliert. Um den Schalter zu öffnen, können große positive Gate-Spannungen zugelassen werden. Dadurch ist ein großer Eingangsspannungsbereich möglich. Um einen möglichst großen Eingangsspannungsbereich zu erhalten, können statt einzelner MOS-FETs CMOS-Schalter aus zwei komplementären Transistoren Verwendet werden.

In der GaAs-MESFET-Technologie bildet das Gate des Transistors jedoch einen Schottky-Kontakt mit dem Kanal. Aus diesem Grunde fließen erhebliche Gate-Ströme, falls das Gate-Potential das Drain-Potential bzw. das Source-Potential um mehr als 0,5 V übersteigt. Daher können GaAs-Transistoren als Schalter nur dann eingesetzt werden, wenn der Eingangsspannungsbereich und die Gate-Spannung bestimmte Bedingungen erfüllen, die zu kleinen Eingangsbereichen führen. Eine Möglichkeit der Änderung des Eingangsbereiches liegt in der Änderung des Transistoraufbaus, da beispielsweise die Schwellenspannung des Transistors durch Vertiefung des Kanals unter dem Gate erhöht werden kann. Durch derartige Maßnahmen erhöhen sich jedoch auch, wie nachfolgend beschrieben wird, der Schaltfehler bzw. die Schaltzeiten des Schalters.

Durch Betrachtung der Grenzfrequenzen eines symmetrischen Transistormodelles läßt sich nachweisen, daß ein hochauflösender Schalter nur in einem kleinen Frequenzbereich realisiert werden kann.

Nachfolgend sei das sog. Transientenverhalten des GaAs-Schalters nach den Fig. 3 bzw. 4 betrachtet. Durch die Ladungsübertragung zwischen dem Schalttransistor T1 und den Lastkapazitäten CS, CL werden Schaltfehler und ein sog. Taktdurchgriff verursacht. Fig. 5 zeigt ein Ersatzschaltbild zur Bestimmung der Schaltfehler und Schaltzeiten.

Bei dem Übergang der Schaltung zwischen dem Folge-Zustand und dem Halte-Zustand wird durch die Ladungsinjektion und die negative Gate-Spannung eine negative Fehlerspannung den Spannungen an den Eingangs- bzw. Ausgangsknoten S, D überlagert. Die auf den Eingangsknoten S injizierte Ladung kann durch einen Eingangswiderstand RS abfließen, so daß diese Fehlerspannung schnell exponentiell abklingt. Hierbei wird die sich verringernde Fehlerspannung als ein Schaltrauschen definiert.

Die auf den Ausgangsknoten D injizierte Ladung kann durch den Transistorkanal und den Eingangswiderstand RS abfließen, falls sich der Transistor T1 noch nicht in seinem Abschnürbereich befindet. Im Abschnürbereich ergibt sich ein Kanalwiderstand des Schalttransistors T1 von einigen MEGAOHM, wodurch sich eine sehr lange Entladedauer einstellt. Demzufolge hält dieser Schaltfehler während der gesamten Haltephase an. Beim Übergang in den sog. Folgemodus, bei dem der Schalter geschlossen ist, entsteht wegen der Ladungsaufnahme der Transistorkapazitäten, welche bei dem E-FET durch die positive Gate-Spannung besonders groß ist, dagegen eine positive Fehlerspannung an beiden Knoten S, D. Diese Fehlerspannungen werden als Schaltrauschen bezeichnet, da eine schnelle Entladung in diesem Übergang stattfindet. Die Schaltfehlerspannung bzw. das Schaltrauschen sind komplexe Funktionen der Steigung der Gate-Spannung, des Eingangssignales US, der Lastimpedanz und der Transistorgröße. Die Abhängigkeit des Schaltfehlers von dem Eingangssignalpegel und der Anstiegsrate der Gate-Spannung beeinflussen den Klirrfaktor der Abtastschaltung, wie sich durch Differentialgleichungen nachweisen läßt. Eine gewisse Fehlerkompensation wird bei dem bekannten GaAs-FET-Abtastschalter gemäß Fig. 4 durch den Einsatz der Dioden D1 und D2 erreicht, die die Transientenfehler aufgrund des Taktdurchgriffes und der Ladungsverschiebung beim Schaltvorgang anteilig kompensieren. Jedoch bleiben auch bei dieser Fehler-kompensierten Schaltung Transientenfehler bestehen. Zudem hat der hier gezeigte GaAs-FET-Abtastschalter nur eine geringe Sperrdämpfung.

Im Stand der Technik ist im Falle von Si-MOS-Schaltern die Verwendung eines einzelnen Dummy-Transistors vorgeschlagen worden. Hierzu wird auf folgende Literaturstelle verwiesen:

Eichenberger, C., Guggenbühl, W.: Dummy Transistor Compensation of Analog MOS Switches. IEEE J. of SCC, Vol. 24, Nr. 4, August 1989, S. 1143-1146.

Die symmetrische Anordnung von Dummy-Transistoren, gemäß Oberbegriff des Anspruches 1, ist aus der Literaturstelle ELEKTRONIK, Bd. 39, Nr. 5, 2. März 1990, Seiten 100-110, J. WALTER et al. "Integrierbare Funktionblöcke und Systeme" bekannt.

Ausgehend von diesem Stand der Technik liegt der vorliegenden Erfindung die Aufgabe zugrunde, einen FET- Analogschalter der eingangs genannten Art zu schaffen, der geringere Transientenfehler und eine verbesserte Sperrdämpfung aufweist.

Diese Aufgabe wird durch einen FET-Analogschalter gemäß Patentanspruch 1 gelöst.

Die erfindungsgemäße Struktur des Analogschalters in GaAs-Technologie bewirkt eine kleinere Fehlerspannung und Abhängigkeit von den Eingangssignalen, eine geringere Schaltrauschamplitude und eine verkürzte Einschwingzeit.

Bevorzugte Weiterbildungen des Erfindungsgegenstandes sind in den abhängigen Ansprüchen definiert.

Nachfolgend werden unter Bezugnahme auf die beiliegenden Zeichnungen Ausführungsbeispiele des Erfindungsgegenstandes näher erläutert. Es zeigen:

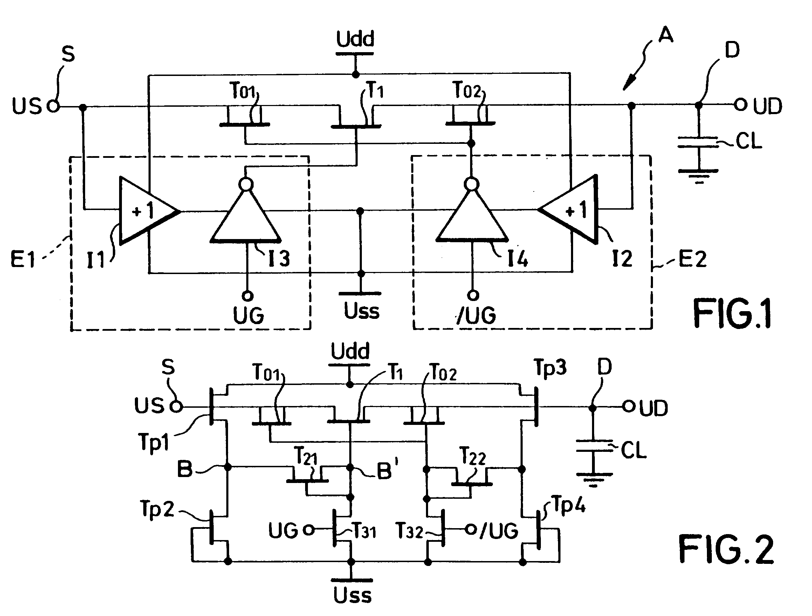

- Fig. 1: die Grundstruktur eines Ausführungsbeispieles des erfindungsgemäßen FET-Analogschalters;
- Fig. 2: eine detaillierte Realisierung eines Ausführungsbeispieles des erfindungsgemäßen FET-Analogschalters;
- Fig. 3: die Grundstruktur eines bekannten FET-Analogschalters;
- Fig. 4: die Realisierung eines bekannten FET-Analogschalters; und
- Fig. 5: ein Ersatzschaltbild des Transistorlängsschalters, wie er bei den Analogschaltern nach den Fig. 3 und 4 verwendet wird, zur Bestimmung des Transientenverhaltens.

Diejenigen Teile und Komponenten der nunmehr unter Bezugnahme auf die Fig. 1 und 2 zu beschreibenden Ausführungsformen des erfindungsgemäßen FET-Analogschalters, der vorzugsweise als GaAs-FET-Analogschalter ausgeführt ist, die den Teilen bzw. Komponenten des bekannten, bereits beschriebenen Analogschalters nach den Fig. 3 und 4 entsprechen, sind mit gleichen Bezugszeichen bezeichnet, so daß eine erneute Beschreibung dieser Teile unterbleiben kann.

Fig. 1 zeigt ein Blockdiagramm des erfindungsgemäßen GaAs-FET-Analogschalters, der wiederum in seiner Gesamtheit mit dem Bezugszeichen A bezeichnet wird. Der erfindungsgemäße FET-Analogschalter A, der vorzugsweise als GaAs-FET-Analogschalter ausgeführt ist, umfaßt einen ersten und einen zweiten Dummy-Transistor T01, T02, deren Drain-Source-Strekken einerseits zwischen dem Eingangsknoten S und der Source-Elektrode des Schalttransistors T1 und andererseits zwischen der Drain-Elektrode des Schalttransistors T1 und dem Ausgangsknoten B geschaltet sind. Eine erste Treiberschaltung E1 wird eingangsseitig von dem Abtaststeuersignal UG beaufschlagt und ist ausgangsseitig mit dem Gate des Schalttransistors T1 verbunden. Der ersten Treiberschaltung werden ferner die beiden Versorgungspotentiale Udd, Uss des Analogschalters A sowie das Eingangssignal am Eingangsknoten S zugeführt.

Gemäß der Erfindung umfaßt der Analogschalter A ferner eine zweite Treiberschaltung E2 für die Ansteuerung der Gates der beiden Dummy-Transistoren T01, T02 gegenphasig zu der Ansteuerung der Gates des Schalttransistors T1 durch die erste Treiberschaltung E1. Bei dem hier gezeigten, nicht beschränkenden Blockdiagramm wird die gegenphasige Ansteuerung dadurch bewerkstelligt, daß der zweiten Treiberschaltung das logisch negierte Abtaststeuersignal/UG bezogen auf das Abtaststeuersignal UG zugeführt wird, mit dem der Abtastvorgang durch die erste Treiberschaltung gesteuert wird. Für den Fachmann ist es jedoch offenkundig, daß jegliche andere Maßnahme, die zu einer gegenphasigen Ansteuerung der Gates der beiden Dummy-Transistoren T01, T02 bezogen auf die Ansteuerung des Gates des Schalttransistors T1 führt, ebenfalls eingesetzt werden kann.

Gemäß einem wichtigen Aspekt des Erfindungsgegenstandes umfaßt die erste Treiberschaltung einen ersten Impedanzwandler I1, dessen Eingang mit dem Eingangsknoten S des FET- Analogschalters A verbunden ist. Der erste Impedanzwandler I1 wird mit den beiden Versorgungspotentialen Udd, Uss des FET-Analogschalters A versorgt. Ferner umfaßt die erste Treiberschaltung E1 eine erste Ansteuerschaltung, deren Eingang das Abtaststeuersignal UG zugeführt wird und deren eines Versorgungspotential durch das Ausgangssignal des ersten Impedanzwandlers I1 gebildet wird. Ferner wird diese Ansteuerschaltung I3 mit einem der beiden festen Versorgungspotentiale Uss des Analogschalters versorgt. Bei dem hier gezeigten Ausführungsbeispiel ist die erste Ansteuerschaltung durch eine erste Inverterschaltung I3 realisiert, obwohl dies für den Gegenstand der Erfindung nicht zwingend ist.

Der Ausgang der ersten Ansteuerschaltung bzw. Inverterschaltung I3 ist mit dem Gate des Schalttransistors T1 verbunden.

Daher wird das Gate des ersten Schalttransistors T1 in Abhängigkeit von dem logischen Zustand des Abtaststeuersignales UG mit Steuerpotentialen beaufschlagt, die von der Spannung am Eingangsknoten S bzw. einem der beiden Versorgungspotentiale Uss abhängen.

Gemäß einem weiteren wichtigen Aspekt der Erfindung umfaßt die zweite Treiberschaltung E2 einen zweiten Impedanzwandler I2, dessen Eingang mit dem Ausgangsknoten D des Analogschalters A verbunden ist und der bei dem hier gezeigten praktisch realisierten Ausführungsbeispiel mit den beiden Versorgungspotentialen Udd, Uss der Abtastschaltung versorgt wird.

Ferner umfaßt die zweite Treiberschaltung E2 eine zweite Ansteuerschaltung, die bei der gezeigten beispielshaften Ausführungsform durch eine zweite Inverterschaltung I4 realisiert ist. Der Eingang der zweiten Ansteuerschaltung I4 wird mit dem negierten Abtaststeuersignal /UG beaufschlagt. Eines der Versorgungspotentiale der zweiten Ansteuerschaltung I4 wird durch das Ausgangssignal des zweiten Impedanzwandlers I2 gebildet, so daß dieses Versorgungspotential dem Potential am Ausgangsknoten D folgt. Ferner wird die zweite Ansteuerschaltung I4 von dem zweitgenannten der beiden Versorgungspotentiale Uss versorgt. Der Ausgang der zweiten Ansteuerschaltung I4 ist mit den Gates der beiden Dummy-Transistoren T01, T02 verbunden.

Nachfolgend wird die in Fig. 2 gezeigte Realisierung der Ausführungsform, deren Ersatzschaltbild in Fig. 1 dargestellt ist, erläutert.

Der erste Impedanzwandler I1 umfaßt zwei mit ihren Drain-Source-Strecken in Reihe zwischen den beiden Versorgungspotentialen Udd, Uss geschaltete Puffertransistoren Tp1, Tp2, sowie einen ersten Ansteuertransistor T21, der zwischen dem gemeinsamen Knoten B der beiden Puffertransistoren Tp1, Tp2 und der Gate-Elektrode des Schalttransistors T1 geschaltet ist. Das Gate des ersten Puffertransistors Tpl ist mit dem Eingangsknoten S verbunden. Das Gate des zweiten Puffertransistors Tp2 ist mit dem zweiten Versorgungspotential Uss beaufschlagt. Ferner ist das Gate des ersten Ansteuertransistors T21 mit dem Gate des ersten Schalttransistors T1 verbunden.

Die erste Inverterschaltung I3 wird durch den ersten Invertertransistor T31 gebildet, dessen Drain-Source-Strecke zwischen dem Gate des ersten Schalttransistors und dem zweiten Versorgungspotential Uss liegt und dessen Gate von dem Abtaststeuersignal UG beaufschlagt wird.

In ähnlicher Weise umfaßt die zweite Impedanzwandlerschaltung I2 einen dritten und vierten Puffertransistor Tp3, Tp4, deren Drain-Source-Strecken in Reihe zueinander zwischen den beiden Versorgungspotentialen Udd, Uss liegen. Das Gate des dritten Puffertransistors Tp3 ist mit dem Ausgangsknoten D verbunden, währen dasjenige des vierten Puffertransistors Tp4 mit dem zweiten Versorgungspotential Uss beaufschlagt ist. Der gemeinsame Knoten des dritten und vierten Puffertransistors Tp3, Tp4 ist über einen zweiten Ansteuertransistor T22 mit den beiden Gates der beiden Dummy-Transistoren T01, T02 verbunden. Das Gate des zweiten Ansteuertransistors T22 ist gleichfalls mit den beiden Gates der Dummy-Transistoren T01, T02 verbunden. Die zweite Inverterschaltung I4 wird durch einen zweiten Invertertransistor T32 gebildet, dessen Drain-Source-Strecke zwischen den Gates der beiden Dummy-Transistoren T01, T02 und dem zweiten Versorgungspotential Uss geschaltet ist und dessen Gate von dem negierten Abtaststeuersignal/UG beaufschlagt wird.

Durch die beiden Dummy-Transistoren T01, T02 werden Transientenfehler, die Fehlerspannungen beim ausgeschalteten Zustand sowie das Schaltrauschen beim eingeschalteten Zustand auf dem Ausgangsknoten D und dem Eingangsknoten S gleichzeitig ausgeglichen. Diese Eigenschaft des erfindungsgemäßen FET-Analogschalters erlangt eine wichtige Bedeutung bei Analogschaltern mit parasitärer Eingangskapazität, die bei vielen Anwendungen nicht verhindert werden kann. Durch diese Maßnahme erhält man nicht nur eine kleinere Fehlerspannung und eine geringere Abhängigkeit von Eingangssignalen, welche einen wesentlichen Anteil des Klirrfaktors einer derartigen Analogschaltung darstellen, sondern auch eine geringere Schaltrauschamplitude oder Einschwingzeit gegenüber bekannten Analogschaltern.

Der erfindungsgemäße FET-Analogschalter erreicht den gleichen Eingangsspannungsbereich wie der Analogschalter nach dem Stand der Technik gemäß Fig. 4. Jedoch erreicht der erfindungsgemäße FET-Analogschalter eine bessere Sperrdämpfung. Dies beruht darauf, daß bei dem erfindungsgemäßen FET-Analogschalter verglichen mit dem Stand der Technik nach Fig. 4 durch die erfindungsgemäße symmetrische Ausführungsform die Dioden zwischen dem Source des Puffertransistors Tp1 und dem Gate des Schalttransistors T1 wegfallen. Hierdurch erhält man eine erhöhte Impedanz zwischen den Knoten B und B' bei dem erfindungsgemäßen FET-Analogschalter. Die Signalamplitude an dem Knoten B', die sich über die Gate-Drain-Kapazität des Schalttransistors T1 auf den Schaltungsausgang D koppelt, wird somit vermindert.

## Patentansprüche

1. FET-Analogschalter,
mit einem Eingangsknoten (S), an den ein Analogsignal anlegbar ist, einem Ausgangsknoten (D), an den ein Abschlußelement (CL) anschließbar ist, einem Schalttransistor (T1), der zwischen dem Eingangsknoten (S) und dem Ausgangsknoten (D) angeordnet ist, und einer ersten Treiberschaltung (E1) für die Ansteuerung des Gates des Schalttransistors (T1) in Abhängigkeit von einem Abtaststeuersignal (UG),
mit einem ersten und einen zweiten Dummy-Transistor (T01, T02), deren jeweils Kurzgeschlossene Drain-Source-Strecken einerseits zwischen dem Eingangsknoten (S) und der Drain-Source-Strecke des Schalttransistors (T1) und andererseits zwischen der Drain-Source-Strecke des Schalttransistors (T1) und dem Ausgangsknoten (D) geschaltet sind, und
mit einer zweiten Treiberschaltung (E2) für die Ansteuerung der Gates der beiden Dummy-Transistoren (T01, T02) gegenphasig zu der Ansteuerung des Gates des Schalttransistors (T1) durch die erste Treiberschaltung (E1),
dadurch gekennzeichnet,
daß die ersten Treiberschaltung (E1) einen ersten Impedanzwandler (I1) aufweist, dessen Eingang mit dem Eingangsknoten (S) verbunden ist,
daß die erste Treiberschaltung (E1) ferner eine erste Ansteuerschaltung (I3) aufweist, deren Eingang das Abtaststeuersignal (UG) zugeführt wird und die von dem Potential am Ausgang des ersten Impedanzwandlers (I1) versorgt wird,
daß der Ausgang der ersten Ansteuerschaltung (I3) mit dem Gate des Schalttransistors (T1) verbunden ist,
daß die zweite Treiberschaltung (E2) einen zweiten Impedanzwandler (I2) aufweist, dessen Eingang mit dem Ausgangsknoten (D) verbunden ist,
daß die zweite Treiberschaltung (E2) ferner eine zweite Ansteuerschaltung (I4) aufweist, deren Eingang das negierte Abtaststeuersignal (/UG) zugeführt wird und die von dem Potential am Ausgang des zweiten Impedanzwandlers (I2) versorgt wird, und
daß der Ausgang der zweiten Ansteuerschaltung (I4) mit den Gates der Dummy-Transistoren (T01, T02) verbunden ist.

2. FET-Analogschalter nach Anspruch 1, dadurch gekennzeichnet daß der erste Impedanzwandler (I1) einen ersten und einen zweiten, mit den Drain-Source-Strecken in Reihe zwischen einem ersten und einem zweiten Versorgungspotential (Udd, Uss) geschalteten Puffertransistor (Tp1, Tp2) aufweist, wobei das Gate des ersten Puffertransistors (Tp1) mit dem Eingangsknoten (S) und das Gate des zweiten Puffertransistors (Tp2) mit dem zweiten Versorgungspotential (Uss) beaufschlagt ist, und daß die erste Ansteuerschaltung (13) einen ersten Ansteuertransistor (T21) aufweist, dessen Drain-Source-Strecke zwischen dem gemeinsamen Knoten des ersten und zweiten Puffertransistors (Tp1, Tp2) und dem Gate des Schalttransistors (T1) liegt und dessen Gate mit dem Gate des Schalttransistors (T1) verbunden ist.

3. FET-Analogschalter nach Anspruch 1 oder 2, dadurch gekennzeichnet daß der zweite Impedanzwandler (12) einen dritten und einen vierten, mit ihren Drain-Source-Strecken in Reihe zwischen einem ersten und einem zweiten Versorgungspotential (Udd, Uss) geschalteten Puffertransistor (Tp3, Tp4) aufweist, wobei das Gate des dritten Puffertransistors (Tp3) mit dem Ausgangsknoten (D) und das Gate des vierten Puffertransistors (Tp4) mit dem zweiten Versorgungspotential (Uss) beaufschlagt ist, und daß die zweite Ansteuerschaltung einen zweiten Ansteuertransistor (T22) aufweist, dessen Drain-Source-Strecke zwischen dem gemeinsamen Knoten des dritten und vierten Puffertransistors (Tp3, Tp4) und den Gates der Dummy-Transistoren (T01, T02) liegt und dessen Gate mit den Gates der Dummy-Transistoren (T01, T02) verbunden ist.

4. FET-Analogschalter nach einem der Ansprüche 1 bis 3, dadurch gekennzeichnet,
daß der FET-Analogschalter als GaAs-FET-Analogschalter ausgeführt ist.

## Claims

1. An FET analog switch comprising
an input node (S) adapted to have applied thereto an analog signal, an output node (D) adapted to have connected thereto a terminating element (CL), a switching transistor (T1) arranged between said input node (S) and said output node (D), and a first drive circuit (E1) for controlling the gate of the switching transistor (T1) in dependence upon a sampling control signal (UG),
a first and a second dummy transistor (T01, T02) whose respective short-circuited drain-source paths are connected between the input node (S) and the drain-source path of the switching transistor (T1) on the one hand and the drain-source path of the switching transistor (T1) and the output node (D) on the other, and
a second drive circuit (E2) for controlling the gates of the two dummy transistors (T01, T02) in phase opposition to the control of the gate of the switching transistor (T1) by the first drive circuit (E1),
characterized in
that the first drive circuit (E1) includes a first impedance transformer (I1) whose input is connected to the input node (S),
that the first drive circuit (E1) additionally includes a first control circuit (I3) whose input has applied thereto the sampling control signal (UG), said first control circuit (I3) being supplied by the potential at the output of the first impedance transformer (I1),
that the output of said first control circuit (I3) is connected to the gate of the switching transistor (T1),
that the second drive circuit (E2) includes a second impedance transformer (I2) whose input is connected to the output node (D),
that the second drive circuit (E2) additionally includes a second control circuit (I4) whose input has applied thereto the negated sampling control signal (/UG), said second control circuit (I4) being supplied by the potential at the output of the second impedance transformer (I2), and
that the output of said second control circuit (I4) is connected to the gates of the dummy transistors (T01, T02).

2. An FET analog switch according to claim 1, characterized in
that said first impedance transformer (I1) comprises first and second buffer transistors (Tp1, Tp2) which have their drain-source paths connected in series between a first and a second supply potential (Udd, Uss), the gate of the first buffer transistor (Tp1) having applied thereto the input node (S) and the gate of the second buffer transistor (Tp2) having applied thereto the second supply potential (Uss), and
that the first control circuit (I3) comprises a first control transistor (T21) whose drain-source path lies between the common node of the first and second buffer transistors (Tp1, Tp2) and the gate of the switching transistor (T1) and whose gate is connected to the gate of the switching transistor (T1).

3. An FET analog switch according to claim 1 or 2, characterized in
that said second impedance transformer (I2) comprises third and fourth buffer transistors (Tp3, Tp4) which have their drain-source paths connected in series between a first and a second supply potential (Udd, Uss), the gate of the third buffer transistor (Tp3) having applied thereto the output node (D) and the gate of the fourth buffer transistor (Tp4) having applied thereto the second supply potential (Uss), and
that the second control circuit comprises a second control transistor (T22) whose drain-source path lies between the common node of the third and fourth buffer transistors (Tp3, Tp4) and the gates of the dummy transistors (T01, T02) and whose gate is connected to the gates of the dummy transistors (T01, T02).

4. An FET analog switch according to one of the claims 1 to 3, characterized in
that the FET analog switch is an GaAs-FET analog switch.

## Revendications

1. Commutateur analogique à FET,
avec un noeud d'entrée (S) auquel peut être amené un signal analogique, un noeud de sortie (D) auquel peut être raccordé un élément de terminaison (CL), un transistor de commutation (T1) qui est disposé entre le noeud d'entrée (S) et le noeud de sortie (D), et un premier circuit d'excitation (E1) destiné à commander le déclenchement du transistor de commutation (T1) en fonction du signal de commande de balayage (UG),
avec un premier et un second transistor fictif (T01, T02) dont les trajets décharge-source, chacun en court-circuit, sont connectés, d'une part, entre le noeud d'entrée (S) et le trajet décharge-source du transistor de commutation (T1) et, d'autre part, entre le trajet décharge-source du transistor de commutation (T1) et le noeud de sortie (B), et
avec un second circuit d'excitation (E2) destiné à commander le déclenchement des deux transistors fictifs (T01, T02) en phase opposée à la commande du déclenchement du transistor de commande (T1) par le premier circuit d'excitation (E1),
caractérisé par le fait
que le premier circuit d'excitation (E1) présente un premier convertisseur d'impédance (I1) dont l'entrée est reliée au noeud d'entrée (S),
que le premier circuit d'excitation (E1) présente, par ailleurs, un premier circuit de commande (I3) à l'entrée duquel est amené le signal de commande de balayage (UG) et qui est alimenté par le potentiel à la sortie du premier convertisseur d'impédance (I1),
que la sortie du premier circuit de commande (I3) est reliée à la porte du transistor de commande (T1),
que le second circuit d'excitation (E2) présente un second convertisseur d'impédance (I2) dont l'entrée est reliée au noeud de sortie (D),
que le second circuit d'excitation (E2) présente, par ailleurs, un second circuit de commande (I4) à l'entrée duquel est amené le signal de commande de balayage rendu négatif (/UG) et qui est alimenté par le potentiel à la sortie du second convertisseur d'impédance (I2), et
que la sortie du second circuit de commande (I3) est reliée à la porte des transistors fictifs (T01, T02).

2. Commutateur analogique à FET suivant la revendication 1, caractérisé par le fait
que le premier convertisseur d'impédance (I1) présente un premier et un second transistor-tampon (Tp1, Tp2) connectés, par les trajets décharge-source, en série entre un premier et un second potentiel d'alimentation (Udd, Uss), la porte du premier transistor-tampon (Tp1) étant reliée au noeud d'entrée (S) et la porte du second transistor-tampon (Tp2) étant soumise à l'admission du second potentiel d'alimentation (Uss), et
que le premier circuit de commande (I3) présente un premier transistor de commande (T21) dont le trajet décharge-source se situe entre le noeud commun du premier et du second transistor-tampon (Tp1, Tp2) et la porte du transistor de commutation (T1) et dont la porte est reliée à la porte du transistor de commutation (T1).

3. Commutateur analogique à FET suivant la revendication 1 ou 2, caractérisé par le fait
que le second convertisseur d'impédance (I2) présente un troisième et un quatrième transistor-tampon (Tp3, Tp4) connectés, par leurs trajets décharge-source, en série entre un premier et un second potentiel d'alimentation (Udd, Uss), la porte du troisième transistor-tampon (Tp3) étant reliée au noeud de sortie (D) et la porte du quatrième transistor-tampon (Tp4) étant soumise à l'admission du second potentiel d'alimentation (Uss), et
que le second circuit de commande présente un second transistor de commande (T22) dont le trajet décharge-source se situe entre le noeud commun du troisième et du quatrième transistor-tampon (Tp3, Tp4) et la porte des transistors fictifs (T01, T02) et dont la porte est reliée à la porte des transistors fictifs (T01, T02).

4. Commutateur analogique à FET suivant l'une des revendications 1 à 3, caractérisé par le fait que le commutateur analogique à FET se présente sous forme de commutateur analogique à FET en GaAs.
